# EUROPEAN PATENT APPLICATION

(11) **EP 4 761 104 A1**
(43) Date of publication of application: **17.06.2026**
(21) Application number: 25222364.9
(22) Date of filing: 10.12.2025
(51) Int. Cl.: H03F 1/02, H03F 3/195, H03F 3/21, H03F 3/24

(54) **REDUCING EQUIVALENT SERIES RESISTANCE IN A POWER MANAGEMENT CIRCUIT DURING SINGLE TRANSMISSION**

(30) Priority: 13.12.2024 US 202463733476 P; 21.01.2025 US 202563747443 P; 10.11.2025 US 202519383962
(71) Applicant: QORVO US, INC., Greensboro, NC 27409 (US)
(72) Inventor: KHLAT, Nadim, Greensboro,, 27409 (US)
(74) Representative: D Young & Co LLP

(57) **Abstract**

Reducing equivalent series resistance (ESR) of a power management circuit during single transmission is disclosed. The power management circuit includes multiple power amplifier circuits each configured to amplify a signal for transmission. The power management circuit includes a main multi-level charge pump (MCP), a first voltage modulation circuit, a lightweight MCP, and a second voltage modulation circuit. When only one of the power amplifiers is active to amplify the signal for single transmission, the power management circuit will opportunistically couple the main MCP, the first voltage modulation circuit, the lightweight MCP, and the second voltage modulation circuit to the active power amplifier. As such, the active power amplifier will see a reduced ESR that is collectively presented by the main MCP, the first voltage modulation circuit, the lightweight MCP, and the second voltage modulation circuit, and can thus operate with improved efficiency during the single transmission.

## Description

### Related Applications

This application claims the benefit of U.S. provisional patent application serial number 63/733,476, filed on December 13, 2024, U.S. provisional patent application serial number 63/747,443, filed on January 21, 2025, and U.S. patent application serial number 19/383,962, filed on November 10, 2025, the disclosures of which are hereby incorporated herein by reference in their entireties.

### Field

The technology of the disclosure relates generally to improving efficiency of a power management circuit during single transmission.

### Background

Mobile communication devices have become increasingly common in current society for providing wireless communication services. The prevalence of these mobile communication devices is driven in part by the many functions that are now enabled on such devices. Increased processing capabilities in such devices means that mobile communication devices have evolved from being pure communication tools into sophisticated mobile multimedia centers that enable enhanced user experiences.

A state-of-the-art mobile communication device must be able to communicate a radio frequency (RF) signal(s) in a variety of wireless communication systems, such as long-term evolution (LTE) and new radio (NR), based on a variety of transmit/receive configurations, such as uplink/downlink multiple-input, multiple-output (UL/DL-MIMO), enhanced dual-connectivity (EN-DC), and diversity receive (DRX). As an example, many multi-transmission proposals have been made for third-generation partnership project (3GPP) release 18 to support concurrent UL-MIMO and EN-DC transmissions on multiple RF bands. In this regard, a wireless communication device is required to concurrently transmit at least three RF signals (2xMIMO + 1xEN-DC). In this regard, the mobile communication device must employ a power management circuit that can simultaneously support multiple power amplifiers to enable multiple concurrent transmissions. In addition, the mobile communication device must also operate efficiently when only one of the power amplifiers is used for transmission.

### Summary

Particular aspects are set out in the appended independent claims. Various optional embodiments are set out in the dependent claims.

Embodiments of the disclosure relate to reducing equivalent series resistance (ESR) in a power management circuit during single transmission. Herein, the power management circuit includes multiple power amplifier circuits each configured to amplify a signal for transmission. The power management circuit includes a main multi-level charge pump (MCP) and a first voltage modulation circuit that can provide a first low-frequency current and a first modulated voltage at a first voltage output, and a lightweight MCP and a second voltage modulation circuit that can provide a second low-frequency current and a second modulated voltage at a second voltage output. When only one of the power amplifiers is active to amplify the signal for single transmission, the power management circuit will opportunistically couple the main MCP, the first voltage modulation circuit, the lightweight MCP, and the second voltage modulation circuit to the active power amplifier to concurrently provide the first low-frequency current, the first modulated voltage, the second low-frequency current, and the second modulated voltage to the active power amplifier. As such, the active power amplifier will see a reduced ESR that is collectively presented by the main MCP, the first voltage modulation circuit, the lightweight MCP, and the second voltage modulation circuit. As a result, the active power amplifier can operate with improved efficiency during the single transmission.

In one aspect, a power management circuit is provided. The power management circuit includes multiple power amplifier circuits. Each of the multiple power amplifier circuits is configured to amplify a signal based on one of a first modulated voltage and a second modulated voltage. The power management circuit also includes a dual output voltage conversion circuit. The dual output voltage conversion circuit includes a main MCP. The main MCP is configured to generate a first low-frequency voltage as a function of a battery voltage to thereby induce a first low-frequency current at a first voltage output. The dual output voltage conversion circuit also includes a lightweight MCP. The lightweight MCP is configured to receive a transfer voltage higher than the battery voltage from the main MCP and generate a second low-frequency voltage as a function of the transfer voltage to thereby induce a second low-frequency current at a second voltage output. The power management circuit also includes a first voltage modulation circuit. The first voltage modulation circuit is configured to generate the first modulated voltage at the first voltage output based on a first modulated target voltage. The power management circuit also includes a second voltage modulation circuit. The second voltage modulation circuit is configured to generate the second modulated voltage at the second voltage output based on a second modulated target voltage. The power management circuit also includes a control circuit. The control circuit is configured to determine that only one of the multiple power amplifier circuits is active to amplify the signal. The control circuit is also configured to cause the main MCP and the lightweight MCP to concurrently provide the first low-frequency current and the second low-frequency current to the determined one of the multiple power amplifier circuits. The control circuit is also configured to cause the first voltage modulation circuit and the second voltage modulation circuit to concurrently provide the first modulated voltage and the second modulated voltage to the determined one of the multiple power amplifier circuits.

In another aspect, a wireless device is provided. The wireless device includes a power management circuit. The power management circuit includes multiple power amplifier circuits. Each of the multiple power amplifier circuits is configured to amplify a signal based on one of a first modulated voltage and a second modulated voltage. The power management circuit also includes a dual output voltage conversion circuit. The dual output voltage conversion circuit includes a main MCP. The main MCP is configured to generate a first low-frequency voltage as a function of a battery voltage to thereby induce a first low-frequency current at a first voltage output. The dual output voltage conversion circuit also includes a lightweight MCP. The lightweight MCP is configured to receive a transfer voltage higher than the battery voltage from the main MCP and generate a second low-frequency voltage as a function of the transfer voltage to thereby induce a second low-frequency current at a second voltage output. The power management circuit also includes a first voltage modulation circuit. The first voltage modulation circuit is configured to generate the first modulated voltage at the first voltage output based on a first modulated target voltage. The power management circuit also includes a second voltage modulation circuit. The second voltage modulation circuit is configured to generate the second modulated voltage at the second voltage output based on a second modulated target voltage. The power management circuit also includes a control circuit. The control circuit is configured to determine that only one of the multiple power amplifier circuits is active to amplify the signal. The control circuit is also configured to cause the main MCP and the lightweight MCP to concurrently provide the first low-frequency current and the second low-frequency current to the determined one of the multiple power amplifier circuits. The control circuit is also configured to cause the first voltage modulation circuit and the second voltage modulation circuit to concurrently provide the first modulated voltage and the second modulated voltage to the determined one of the multiple power amplifier circuits.

In another aspect, a method for reducing ESR of a power management circuit during single transmission is provided. The method includes amplifying a signal based on one of a first modulated voltage and a second modulated voltage. The method also includes generating a first low-frequency voltage as a function of a battery voltage to thereby induce a first low-frequency current at a first voltage output. The method also includes receiving a transfer voltage higher than the battery voltage and generating a second low-frequency voltage as a function of the transfer voltage to thereby induce a second low-frequency current at a second voltage output. The method also includes generating the first modulated voltage at the first voltage output based on a first modulated target voltage. The method also includes generating the second modulated voltage at the second voltage output based on a second modulated target voltage. The method also includes determining that only one of multiple power amplifier circuits is active to amplify the signal. The method also includes concurrently providing the first low-frequency current and the second low-frequency current to the determined one of the multiple power amplifier circuits. The method also includes concurrently providing the first modulated voltage and the second modulated voltage to the determined one of the multiple power amplifier circuits.

Those skilled in the art will appreciate the scope of the present disclosure and realize additional aspects thereof after reading the following detailed description of the illustrative embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
Figure 1 is a schematic diagram of an example wireless device that can be configured according to embodiments of the present disclosure to reduce equivalent series resistance (ESR) of a power management circuit during single transmission;
Figure 2 is a schematic diagram providing an example illustration of the power management circuit in the wireless device of Figure 1;
Figures 3A and 3B are schematic diagrams providing example illustrations of a dual-output voltage conversion circuit that can be provided in the power management circuit of Figure 2 and configured to operate based on various embodiments of the present disclosure;
Figure 4 is a schematic diagram of an example communication device wherein the power management circuit of Figure 2 can be provided; and
Figure 5 is a flowchart of an example process for reducing the ESR of the power management circuit of Figure 2 during single transmission.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments of the disclosure relate to reducing equivalent series resistance (ESR) in a power management circuit during single transmission. Herein, the power management circuit includes multiple power amplifier circuits each configured to amplify a signal for transmission. The power management circuit includes a main multi-level charge pump (MCP) and a first voltage modulation circuit that can provide a first low-frequency current and a first modulated voltage at a first voltage output, and a lightweight MCP and a second voltage modulation circuit that can provide a second low-frequency current and a second modulated voltage at a second voltage output. When only one of the power amplifiers is active to amplify the signal for single transmission, the power management circuit will opportunistically couple the main MCP, the first voltage modulation circuit, the lightweight MCP, and the second voltage modulation circuit to the active power amplifier to concurrently provide the first low-frequency current, the first modulated voltage, the second low-frequency current, and the second modulated voltage to the active power amplifier. As such, the active power amplifier will see a reduced ESR that is collectively presented by the main MCP, the first voltage modulation circuit, the lightweight MCP, and the second voltage modulation circuit. As a result, the active power amplifier can operate with improved efficiency during the single transmission.

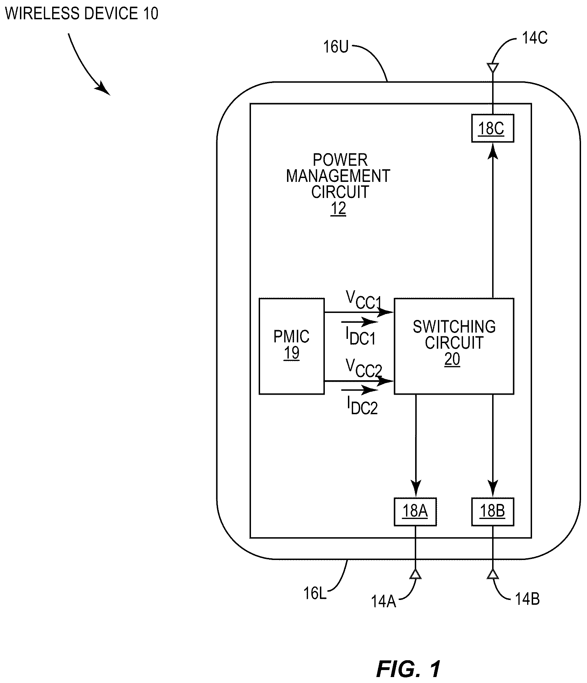

Figure 1 is a schematic diagram of an example wireless device 10 that can be configured according to embodiments of the present disclosure to reduce ESR of a power management circuit 12 during single transmission. In an embodiment, the wireless device 10 includes a first antenna 14A, a second antenna 14B, and a third antenna 14C. In a non-limiting example, the first antenna 14A and the second antenna 14B are provided on a lower edge 16L of the wireless device 10, whereas the third antenna 14C is provided on an upper edge 16U of the wireless device 10.

In the example embodiment, the power management circuit 12 also includes a first power amplifier circuit 18A, a second power amplifier circuit 18B, and a third power amplifier circuit 18C. The first power amplifier circuit 18A and the second power amplifier circuit 18B are provided closer to the first antenna 14A and the second antenna 14B, respectively, than to the third antenna 14C to help reduce coupling distortion. Likewise, the third power amplifier circuit 18C is provided closer to the third antenna 14C than to the first antenna 14A and the second antenna 14B to thereby reduce the coupling distortion therein.

The wireless device 10 may be configured to transmit via any one or more of the first antenna 14A, the second antenna 14B, and the third antenna 14C. In one example, the wireless device 10 can operate in a multiple-input, multiple-output (MIMO) mode to transmit simultaneously via the first antenna 14A and the second antenna 14B. Alternatively, the wireless device 10 may also operate in the MIMO mode to transmit simultaneously via the third antenna 14C and any one of the first antenna 14A and the second antenna 14B. In another example, the wireless device 10 can operate in a MIMO mode and an enhanced dual-connectivity (EN-DC) mode to transmit simultaneously via the first antenna 14A, the second antenna 14B, and the third antenna 14C. In yet another example, the wireless device 10 may operate in a legacy mode to transmit exclusively via the third antenna 14C.

In an embodiment, the power management circuit 12 includes a power management integrated circuit (PMIC) 19 and a switching circuit 20. As further described below, the PMIC 19 is configured to concurrently generate a first modulated voltage V_{CC1}, a first low-frequency current I_{DC1}, a second modulated voltage V_{CC2}, and a second low-frequency current I_{DC2}. The switching circuit 20 includes various types of switches (not shown) that can be controlled to provide any one or more of the first modulated voltage V_{CC1}, the first low-frequency current I_{DC1}, the second modulated voltage V_{CC2}, and the second low-frequency current I_{DC2} to any one or more of the first power amplifier circuit 18A, the second power amplifier circuit 18B, and the third power amplifier circuit 18C according to specific operating modes of the power management circuit 12.

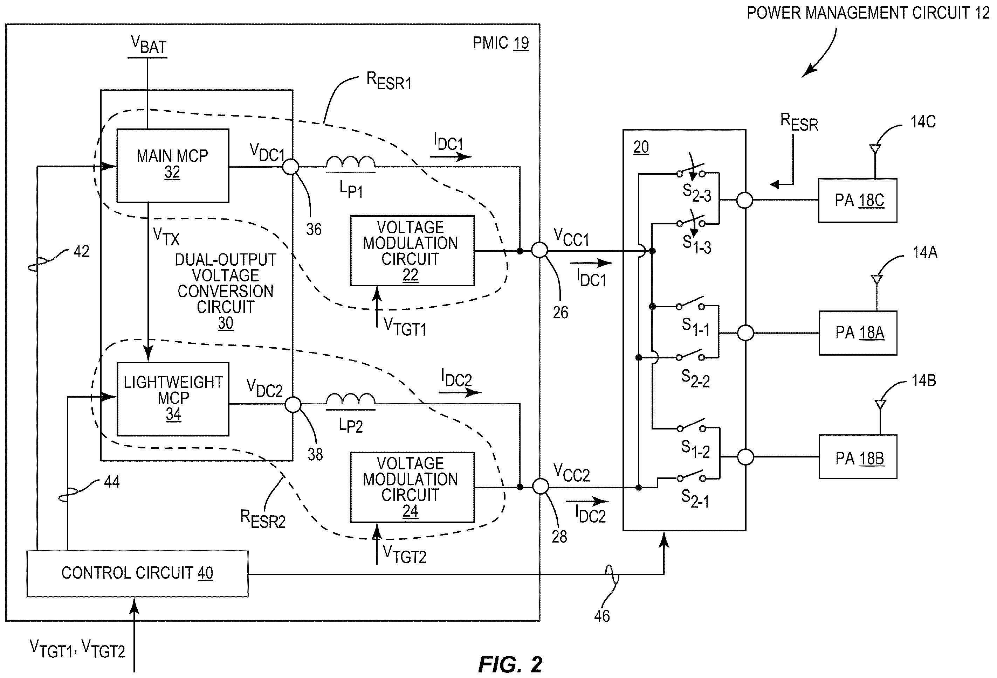

Figure 2 is a schematic diagram providing an example illustration of the power management circuit 12 in the wireless device 10 of Figure 1. Common elements between Figures 1 and 2 are shown therein with common element numbers and will not be re-described herein.

The PMIC 19 includes a first voltage modulation circuit 22 and a second voltage modulation circuit 24. Herein, the first voltage modulation circuit 22 is configured to generate the first modulated voltage V_{CC1} at a first voltage output 26 based on a first modulated target voltage V_{TGT1} and the second voltage modulation circuit 24 is configured to generate the second modulated voltage V_{CC2} at a second voltage output 28 based on a second modulated target voltage V_{TGT2}. Herein, the term "modulated voltage" refers to a voltage (e.g., the first modulated voltage V_{CC1}, the first modulated target voltage V_{TGT1}, the second modulated voltage V_{CC2}, and the second modulated target voltage V_{TGT2}) that is generated in accordance with a time-variant power envelope of a radio frequency (RF) signal.

The PMIC 19 also includes a dual-output voltage conversion circuit 30 that provides the first low-frequency current I_{DC1} and the second low-frequency current I_{DC2} at the first voltage output 26 and the second voltage output 28, respectively. Specifically, the dual-output voltage conversion circuit 30 includes a main MCP 32 and a lightweight MCP 34. The main MCP 32 and the lightweight MCP 34 are configured to simultaneously generate a first low-frequency voltage V_{DC1} and a second low-frequency voltage V_{DC2} at a first low-frequency voltage output 36 and a second low-frequency voltage output 38, respectively. In a non-limiting example, each of the first low-frequency voltage V_{DC1} and the second low-frequency voltage V_{DC2} can be a direct-current (DC) voltage.

In an embodiment, the main MCP 32 is a buck-boost DC-DC voltage conversion circuit that can toggle between a buck mode and a boost mode to generate the first low-frequency voltage V_{DC1} as a function (e.g., a multiple) of a battery voltage V_{BAT}. The lightweight MCP 34, on the other hand, can be a buck-only DC-DC voltage conversion circuit that receives a transfer voltage V_{TX}, which is higher than the battery voltage V_{BAT}, from the main MCP 32. Accordingly, the lightweight MCP 34 can generate the second low-frequency voltage V_{DC2} as a function (e.g., a fraction) of the transfer voltage V_{TX}. By operating based on the transfer voltage V_{TX} that is higher than the battery voltage V_{BAT}, it is possible to eliminate some components (e.g., capacitors) required for boosting the battery voltage V_{BAT} in the lightweight MCP 34. As a result, it is possible to reduce the footprint of the lightweight MCP 34 and the dual-output voltage conversion circuit 30 as a whole.

In an embodiment, the main MCP 32 is configured to provide the transfer voltage V_{TX} that equals 2×V_{BAT} (V_{TX} = 2×V_{BAT}) to the lightweight MCP 34. The lightweight MCP 34 can be configured to toggle between a one-times multiple of the transfer voltage V_{TX} (1×V_{TX} = 2×V_{BAT}), a one-half-times multiple of the transfer voltage V_{TX} (0.5×V_{TX} = 1×V_{BAT}), and a zero-times multiple of the transfer voltage V_{TX} (0×V_{TX} = 0×V_{BAT}) to thereby generate the second low-frequency voltage V_{DC2}.

The PMIC 19 also includes a first power inductor L_{P1} and a second power inductor L_{P2}. The first power inductor L_{P1}, which is coupled between the first low-frequency voltage output 36 and the first voltage output 26, can induce the first low-frequency current I_{DC1} at the first voltage output 26 based on the first low-frequency voltage V_{DC1}. The second power inductor L_{P2}, which is coupled between the second low-frequency voltage output 38 and the second voltage output 28, can induce the second low-frequency current I_{DC2} at the second voltage output 28 based on the second low-frequency voltage V_{DC2}.

The PMIC 19 also includes a control circuit 40. In an embodiment, the control circuit 40 can control the main MCP 32 and the lightweight MCP 34 via a first duty cycle signal 42 and a second duty cycle signal 44, respectively. In an embodiment, the switching circuit 20 includes multiple switches S₁₋₁, S₁₋₂, S₁₋₃, S₂₋₁, S₂₋₂, S₂₋₃ that are coupled as illustrated. Accordingly, the control circuit 40 can also control the switching circuit 20 via a switching control signal 46 to thereby provide any one or more of the first modulated voltage V_{CC1}, the first low-frequency current I_{DC1}, the second modulated voltage V_{CC2}, and the second low-frequency current I_{DC2} to any one or more of the first power amplifier circuit 18A, the second power amplifier circuit 18B, and the third power amplifier circuit 18C.

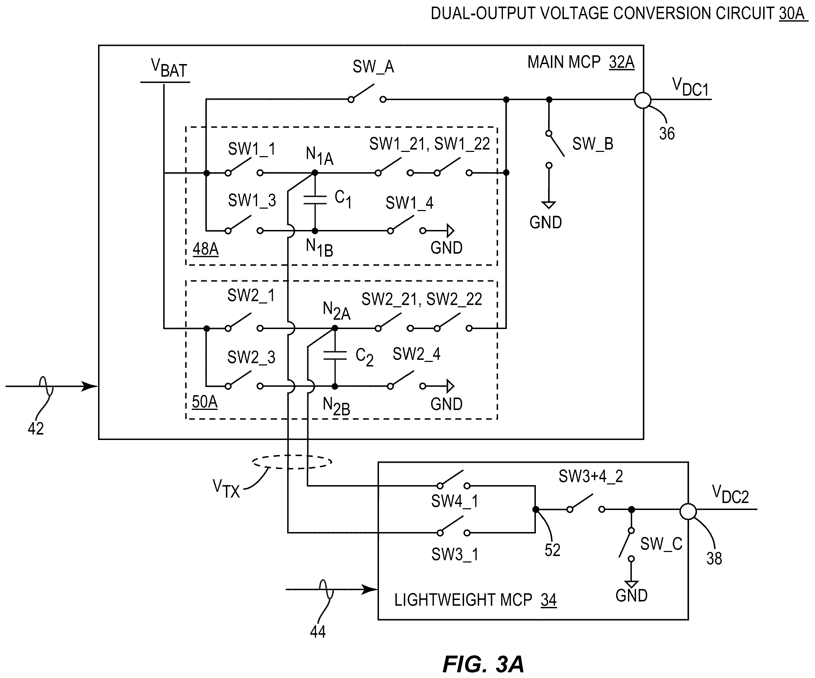

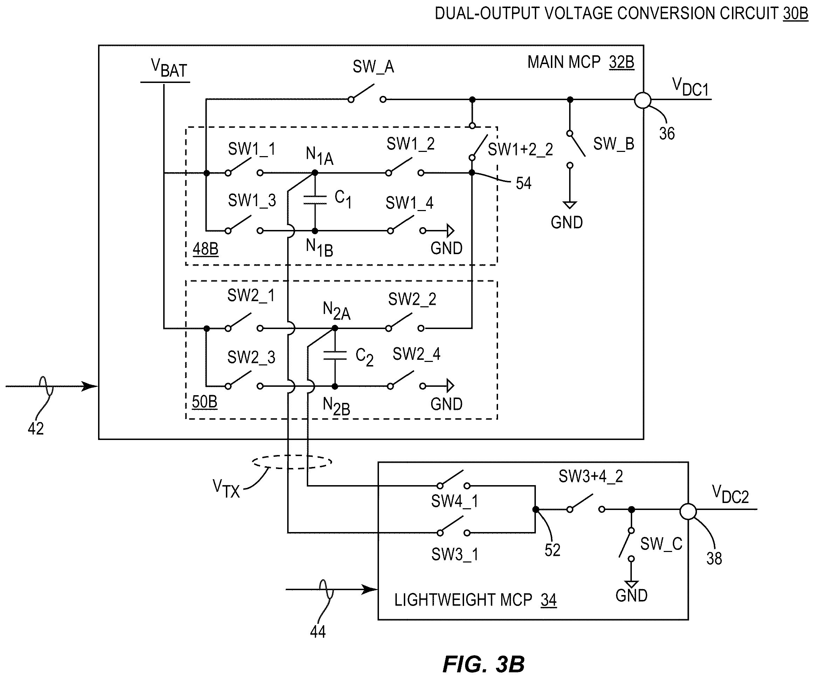

The dual-output voltage conversion circuit 30 may be configured according to various embodiments of the present disclosure, which are further described with reference to Figures 3A and 3B. Common elements between Figures 2, 3A, and 3B are shown therein with common element numbers and will not be re-described herein.

Figure 3A is a schematic diagram of an example dual-output voltage conversion circuit 30A that can be provided in the power management circuit 12 of Figure 2 as the dual-output voltage conversion circuit 30. Herein, the dual-output voltage conversion circuit 30A includes a main MCP 32A and the lightweight MCP 34.

In an embodiment, the main MCP 32A includes a first buck-boost voltage converter 48A and a second buck-boost voltage converter 50A. The first buck-boost voltage converter 48A and the second buck-boost voltage converter 50A are coupled in parallel between the battery voltage V_{BAT} and the first low-frequency voltage output 36. Herein, the first buck-boost voltage converter 48A and the second buck-boost voltage converter 50A are configured to alternately provide the transfer voltage V_{TX} to the lightweight MCP 34. As described below, by configuring the first buck-boost voltage converter 48A and the second buck-boost voltage converter 50A to alternately provide the transfer voltage V_{TX} to the lightweight MCP 34, it is possible to ensure that the lightweight MCP 34 can consistently receive the transfer voltage V_{TX} that equals two times the battery voltage V_{BAT}.

The main MCP 32A may be configured to include a first common switch SW_A and a second common switch SW_B. The first common switch SW_A may be coupled between the battery voltage V_{BAT} and the first low-frequency voltage output 36 and the second common switch SW_B may be coupled between the first low-frequency voltage output 36 and a ground (GND).

The first buck-boost voltage converter 48A includes a respective first switch SW1_1 coupled between the battery voltage V_{BAT} and a respective first middle node N_{1A}, a respective pair of second switches SW1_21, SW1_22 (a.k.a. "first stacked switches") coupled in series between the respective first middle node N_{1A} and the first low-frequency voltage output 36, a respective third switch SW1_3 coupled between the battery voltage V_{BAT} and a respective second middle node N_{1B}, a respective fourth switch SW1_4 coupled between the respective second middle node N_{1B} and the GND, and a respective fly capacitor C₁ coupled between the respective first middle node N_{1A} and the respective second middle node N_{1B}.

The second buck-boost voltage converter 50A includes a respective first switch SW2_1 coupled between the battery voltage V_{BAT} and a respective first middle node N_{2A}, a respective pair of second switches SW2_21, SW2_22 (a.k.a. "second stacked switches") coupled in series between the respective first middle node N_{2A} and the first low-frequency voltage output 36, a respective third switch SW2_3 coupled between the battery voltage V_{BAT} and a respective second middle node N_{2B}, a respective fourth switch SW2_4 coupled between the respective second middle node N_{2B} and the GND, and a respective fly capacitor C₂ coupled between the respective first middle node N_{2A} and the respective second middle node N_{2B}.

One particular benefit of employing the stacked switches SW1_21, SW1_22 is that the stacked switches SW1_21, SW1_22 in the first buck-boost voltage converter 48A can be protected from being damaged by the 2×V_{BAT} presenting at the respective first middle node N_{1A} when the second common switch SW_B is closed. Likewise, the respective pair of second switches SW2_21, SW2_22 in the second buck-boost voltage converter 50A can be protected from being damaged by the 2×V_{BAT} presenting at the respective first middle node N_{2A} when the second common switch SW_B is closed. As a result, it is possible to operate the main MCP 32 based on a shorter duty cycle than that of the lightweight MCP 14.

According to an embodiment of the present disclosure, the respective first middle node N_{1A} in the first buck-boost voltage converter 48A and the respective first middle node N_{2A} in the second buck-boost voltage converter 50A are each coupled to the lightweight MCP 34. Accordingly, the first buck-boost voltage converter 48A and the second buck-boost voltage converter 50A are configured to alternately provide the transfer voltage V_{TX} to the lightweight MCP 34 by alternately coupling the respective first middle node N_{1A} and the respective first middle node N_{2A} to the lightweight MCP 34.

In a non-limiting example, the main MCP 32A can output 1×V_{BAT} at the first low-frequency voltage output 36 by closing exclusively the first common switch SW_A and output 0×V_{BAT} at the first low-frequency voltage output 36 by closing exclusively the second common switch SW_B. To output 2×V_{BAT} at the first low-frequency voltage output 36, the main MCP 32A first charges the first fly capacitor C₁ and/or the second fly capacitor C₂ to the battery voltage V_{BAT}.

In an example, to configure the first buck-boost voltage converter 48A to output 2×V_{BAT} at the first low-frequency voltage output 36, the respective first switch SW1_1 and the respective fourth switch SW1_4 are first closed, while the respective second switches SW1_21, SW1_22 and the respective third switch SW1_3 are opened, to thereby charge the first fly capacitor C₁ to the battery voltage at the respective first middle node N_{1A}. Subsequently, the respective second switches SW1_21, SW1_22 and the respective third switch SW1_3 are closed, while the respective first switch SW1_1 and the respective fourth switch SW1_4 are opened. As a result, the voltage at the respective first middle node N_{1A} will be equal to 2×V_{BAT}. Accordingly, the first buck-boost voltage converter 48A can output 2×V_{BAT} at the first low-frequency voltage output 36 and provide the transfer voltage V_{TX} that is substantially equal to 2×V_{BAT} to the lightweight MCP 34 via the respective first middle node N_{1A}. Herein, the transfer voltage V_{TX} is said to be substantially equal to (a.k.a. approximately equal to) 2×V_{BAT} when a difference between the transfer voltage V_{TX} is equal to ±1% of 2×V_{BAT} (V_{TX} ≈ 2×V_{BAT} ± 1%).

In another example, to configure the second buck-boost voltage converter 50A to output 2×V_{BAT} at the first low-frequency voltage output 36, the respective first switch SW2_1 and the respective fourth switch SW2_4 are first closed, while the respective second switches SW2_21, SW2_22 and the respective third switch SW2_3 are opened, to thereby charge the second fly capacitor C₂ to the battery voltage at the respective first middle node N_{2A}. Subsequently, the respective second switches SW2_21, SW2_22 and the respective third switch SW2_3 are closed, while the respective first switch SW2_1 and the respective fourth switch SW2_4 are opened. As a result, the voltage at the respective first middle node N_{2A} will be equal to 2×V_{BAT}. Accordingly, the second buck-boost voltage converter 50A can output 2×V_{BAT} at the first low-frequency voltage output 36 and provide the transfer voltage V_{TX} that is substantially equal to 2×V_{BAT} to the lightweight MCP 34 via the respective first middle node N_{2A}.

In an embodiment, to ensure that the lightweight MCP 34 can consistently receive the transfer voltage V_{TX} that is substantially equal to 2×V_{BAT}, the main MCP 32A can be configured to alternately charge the first fly capacitor C₁ in the first buck-boost voltage converter 48A and the second fly capacitor C₂ in the second buck-boost voltage converter 50A. Specifically, the respective second switches SW1_21, SW1_22 and the respective third switch SW1_3 in the first buck-boost voltage converter 48A may be closed to provide the transfer voltage V_{TX} that is substantially equal to 2×V_{BAT} to the lightweight MCP 34 via the respective first middle node N_{1A}. In the meantime, the respective first switch SW2_1 and the respective fourth switch SW2_4 in the second buck-boost voltage converter 50A are closed to charge the respective second fly capacitor C₂ to the battery voltage V_{BAT}. When the respective second fly capacitor C₂ is charged up to the battery voltage V_{BAT}, the respective second switches SW2_21, SW2_22 and the respective third switch SW2_3 in the second buck-boost voltage converter 50A are closed to provide the transfer voltage V_{TX} that is substantially equal to 2×V_{BAT} to the lightweight MCP 34 via the respective first middle node N_{2A}. In the meantime, the respective first switch SW1_1 and the respective fourth switch SW1_4 in the first buck-boost voltage converter 48A are closed to charge the respective first fly capacitor C₁ to the battery voltage V_{BAT}.

The lightweight MCP 34 includes a third common switch SW_C that is coupled between the second low-frequency voltage output 38 and the GND. The lightweight MCP 34 also includes a first switch SW3_1, a second switch SW4_1, and a third switch SW3+4_2. Specifically, the first switch SW3_1 is coupled between the respective first middle node N_{1A} in the first buck-boost voltage converter 48A and a common node 52, the second switch SW4_1 is coupled between the respective first middle node N_{2A} in the second buck-boost voltage converter 50A and the common node 52, and the third switch SW3+4_2 is coupled between the common node 52 and the second low-frequency voltage output 38.

The third common switch SW_C can be closed to output 0×V_{BAT} at the second low-frequency voltage output 38. To output 2×V_{BAT} at the second low-frequency voltage output 38, the first switch SW3_1 and the third switch SW3+4_2 can be closed when the first buck-boost voltage converter 48A is providing the transfer voltage V_{TX} via the respective first middle node N_{1A}. Alternatively, the second switch SW4_1 and the third switch SW3+4_2 can be closed when the second buck-boost voltage converter 50A is providing the transfer voltage V_{TX} via the respective first middle node N_{2A}. The lightweight MCP 34 may toggle between 0×V_{BAT} and 2×V_{BAT} based on a 50% duty cycle to thereby output 1×V_{BAT} at the second low-frequency voltage output 38.

Figure 3B is a schematic diagram of an example dual-output voltage conversion circuit 30B that can be provided in the power management circuit 12 of Figure 2 as the dual-output voltage conversion circuit 30. Herein, the dual-output voltage conversion circuit 30B includes a main MCP 32B and the lightweight MCP 34.

In an embodiment, the main MCP 32B includes a first buck-boost voltage converter 48B and a second buck-boost voltage converter 50B. The first buck-boost voltage converter 48B and the second buck-boost voltage converter 50B are coupled in parallel between the battery voltage V_{BAT} and the first low-frequency voltage output 36. Herein, the first buck-boost voltage converter 48B and the second buck-boost voltage converter 50B are configured to alternately provide the transfer voltage V_{TX} to the lightweight MCP 34.

The first buck-boost voltage converter 48B includes a respective first switch SW1_1 coupled between the battery voltage V_{BAT} and a respective first middle node N_{1A}, a respective second switch SW1_2 coupled between the respective first middle node N_{1A} and a coupling node 54, a respective shared switch SW1+2_2 coupled between the coupling node 54 and the first low-frequency voltage output 36, a respective third switch SW1_3 coupled between the battery voltage V_{BAT} and a respective second middle node N_{1B}, a respective fourth switch SW1_4 coupled between the respective second middle node N_{1B} and the GND, and a respective fly capacitor C₁ coupled between the respective first middle node N_{1A} and the respective second middle node N_{1B}.

The second buck-boost voltage converter 50B includes a respective first switch SW2_1 coupled between the battery voltage V_{BAT} and a respective first middle node N_{2A}, a respective second switch SW2_2 coupled between the respective first middle node N_{2A} and the coupling node 54, a respective third switch SW2_3 coupled between the battery voltage V_{BAT} and a respective second middle node N_{2B}, a respective fourth switch SW2_4 coupled between the respective second middle node N_{2B} and the GND, and a respective fly capacitor C₂ coupled between the respective first middle node N_{2A} and the respective second middle node N_{2B}.

In an example, to configure the first buck-boost voltage converter 48B to output 2×V_{BAT} at the first low-frequency voltage output 36, the respective first switch SW1_1 and the respective fourth switch SW1_4 are first closed, while the respective second switch SW1_2, the shared switch SW1+2_2, and the respective third switch SW1_3 are opened, to thereby charge the first fly capacitor C₁ to the battery voltage at the respective first middle node N_{1A}. Subsequently, the respective second switch SW1_2, the shared switch SW1+2_2, and the respective third switch SW1_3 are closed, while the respective first switch SW1_1 and the respective fourth switch SW1_4 are opened. As a result, the voltage at the respective first middle node N_{1A} will be equal to 2×V_{BAT}. Accordingly, the first buck-boost voltage converter 48B can output 2×V_{BAT} at the first low-frequency voltage output 36 and provide the transfer voltage V_{TX} that is substantially equal to 2×V_{BAT} to the lightweight MCP 34 via the respective first middle node N_{1A}.

In another example, to configure the second buck-boost voltage converter 50B to output 2×V_{BAT} at the first low-frequency voltage output 36, the respective first switch SW2_1 and the respective fourth switch SW2_4 are first closed, while the respective second switch SW2_2, the shared switch SW1+2_2, and the respective third switch SW2_3 are opened, to thereby charge the second fly capacitor C₂ to the battery voltage at the respective first middle node N_{2A}. Subsequently, the respective second switch SW2_2, the shared switch SW1+2_2, and the respective third switch SW2_3 are closed, while the respective first switch SW2_1 and the respective fourth switch SW2_4 are opened. As a result, the voltage at the respective first middle node N_{2A} will be equal to 2×V_{BAT}. Accordingly, the second buck-boost voltage converter 50B can output 2×V_{BAT} at the first low-frequency voltage output 36 and provide the transfer voltage V_{TX} that is substantially equal to 2×V_{BAT} to the lightweight MCP 34 via the respective first middle node N_{2A}.

With reference back to Figure 2, when the power management circuit 12 operates in the legacy mode to transmit exclusively via the third antenna 14C, only the third power amplifier circuit 18C will be active. Regardless of whether the third power amplifier circuit 18C is operating based on the first modulated voltage V_{CC1} or the second modulated voltage V_{CC2}, the third power amplifier circuit 18C will see an ESR R_{ESR} presented primarily by the main MCP 32. More specifically, the stacked switches SW1_21, SW1_22 in the first buck-boost voltage converter 48A and the stacked switched switches SW2_21, SW2_22 in the second buck-boost voltage converter 50A can cause the ESR R_{ESR} to increase by four-fold (4×), which can significantly degrade the operating efficiency of the third power amplifier circuit 18C.

To help reduce the ESR R_{ESR} and, thereby, improve the operating efficiency of the third power amplifier circuit 18C in the legacy mode, the power management circuit 12 can be configured to simultaneously couple the main MCP 32, the first voltage modulation circuit 22, the lightweight MCP 34, and the second voltage modulation circuit 24 to the third power amplifier circuit 18C. In an embodiment, the control circuit 40 can simultaneously close the switches S₁₋₃, S₂₋₃ in the switching circuit 20 via the switching control signal 46. By doing so, a respective ESR R_{ESR1} of the main MCP 32, the first power inductor L_{P1}, and the first voltage modulation circuit 22 will become parallel to a respective ESR R_{ESR2} of the lightweight MCP 34, the second power inductor L_{P2}, and the second voltage modulation circuit 24, thus helping to reduce the ESR R_{ESR} seen by the third power amplifier circuit 18C.

Although the ESR reduction scheme as described above is primarily intended for single transmission, it should be appreciated that the power management circuit 12 may also provide any of the first modulated voltage V_{CC1} and the second modulated voltage V_{CC2} to any one of the first power amplifier circuit 18A and the second power amplifier circuit 18B. As an example, the control circuit 40 may further close the switch S₁₋₁ to provide the first modulated voltage V_{CC1} to the first power amplifier circuit 18A or close the switch S₂₋₂ to provide the second modulated voltage V_{CC2} to the first power amplifier circuit 18A.

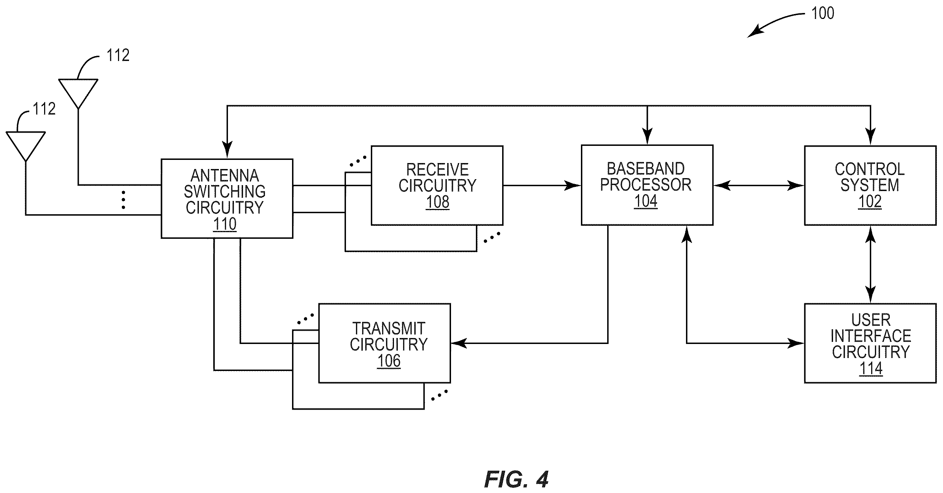

The power management circuit 12 of Figure 2 can be provided in a communication device (e.g., a wireless device) to support the embodiments described above. In this regard, Figure 4 is a schematic diagram of an example communication device 100 wherein the power management circuit 12 of Figure 2 can be provided.

Herein, the communication device 100 can be any type of communication devices, such as mobile terminals, smart watches, tablets, computers, navigation devices, access points, base stations (e.g., eNB, gNB, etc.), and any other type of wireless communication devices that support wireless communications, such as cellular, wireless local area network (WLAN), Bluetooth, Ultra-wideband (UWB), and near field communications. The communication device 100 will generally include a control system 102, a baseband processor 104, transmit circuitry 106, receive circuitry 108, antenna switching circuitry 110, multiple antennas 112, and user interface circuitry 114. In a non-limiting example, the control system 102 can be a field-programmable gate array (FPGA), as an example. In this regard, the control system 102 can include at least a microprocessor(s), an embedded memory circuit(s), and a communication bus interface(s). The receive circuitry 108 receives radio frequency signals via the antennas 112 and through the antenna switching circuitry 110 from one or more base stations. A low noise amplifier and a filter cooperate to amplify and remove broadband interference from the received signal for processing. Downconversion and digitization circuitry (not shown) will then downconvert the filtered, received signal to an intermediate or baseband frequency signal, which is then digitized into one or more digital streams using an analog-to-digital converter(s) (ADC).

The baseband processor 104 processes the digitized received signal to extract the information or data bits conveyed in the received signal. This processing typically comprises demodulation, decoding, and error correction operations, as will be discussed in greater detail below. The baseband processor 104 is generally implemented in one or more digital signal processors (DSPs) and application specific integrated circuits (ASICs).

For transmission, the baseband processor 104 receives digitized data, which may represent voice, data, or control information, from the control system 102, which it encodes for transmission. The encoded data is output to the transmit circuitry 106, where a digital-to-analog converter(s) (DAC) converts the digitally encoded data into an analog signal and a modulator modulates the analog signal onto a carrier signal that is at a desired transmit frequency or frequencies. A power amplifier will amplify the modulated carrier signal to a level appropriate for transmission, and deliver the modulated carrier signal to the antennas 112 through the antenna switching circuitry 110. The multiple antennas 112 and the replicated transmit and receive circuitries 106, 108 may provide spatial diversity. Modulation and processing details will be understood by those skilled in the art.

In an example embodiment, the power management circuit 12 may be provided between the transmit circuitry 106 and the antenna switching circuitry 110. In another example embodiment, the power management circuit 12 may be provided in the antenna switching circuitry 110.

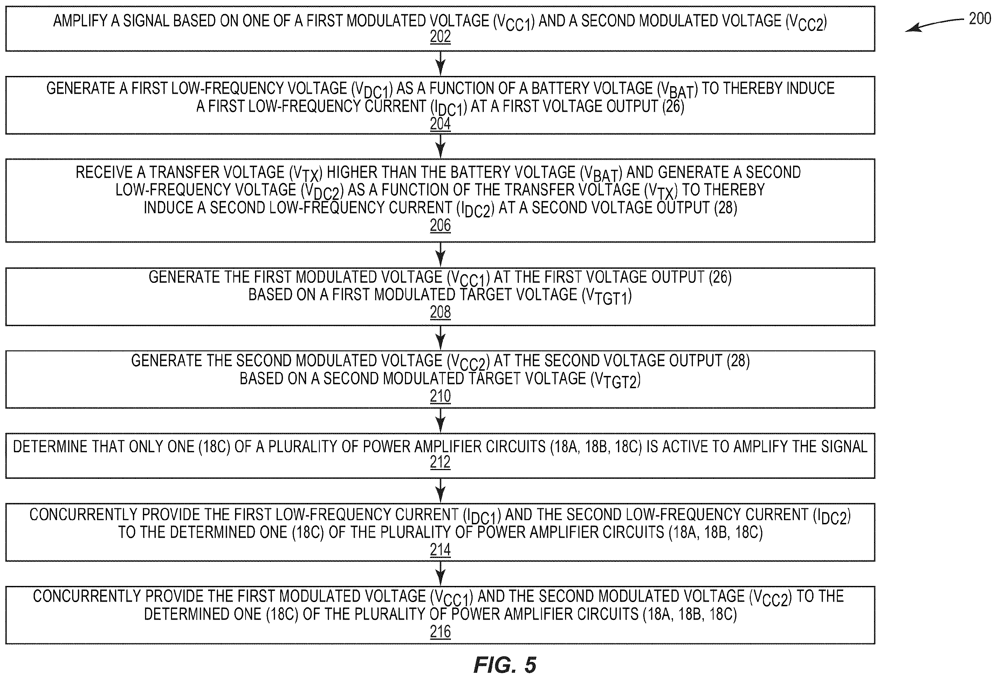

In an embodiment, it is possible to reduce the ESR in the power management circuit 12 of Figure 2 based on a process. In this regard, Figure 5 is a flowchart of an example process 200 for reducing ESR in the power management circuit 12 of Figure 2.

Herein, the process 200 includes amplifying a signal based on one of the first modulated voltage V_{CC1} and the second modulated voltage V_{CC2} (step 202). The process 200 also includes generating the first low-frequency voltage V_{DC1} as a function of the battery voltage V_{BAT} to thereby induce the first low-frequency current I_{DC1} at the first voltage output 26 (step 204). The process 200 also includes receiving the transfer voltage V_{TX} higher than the battery voltage V_{BAT} and generating the second low-frequency voltage V_{DC2} as a function of the transfer voltage V_{TX} to thereby induce the second low-frequency current I_{DC2} at the second voltage output 28 (step 206). The process 200 also includes generating the first modulated voltage V_{CC1} at the first voltage output 26 based on the first modulated target voltage V_{TGT1} (step 208). The process 200 also includes generating the second modulated voltage V_{CC2} at the second voltage output 28 based on the second modulated target voltage V_{TGT2} (step 210). The process 200 also includes determining that only one (e.g., 18C) of the power amplifier circuits 18A, 18B, 18C is active to amplify the signal (step 212). The process 200 also includes concurrently providing the first low-frequency current I_{DC1} and the second low-frequency current I_{DC2} to the determined one (18C) of the power amplifier circuits 18A, 18B, 18C (step 214). The process 200 also includes concurrently providing the first modulated voltage V_{CC1} and the second modulated voltage V_{CC2} to the determined one (18C) of the power amplifier circuits 18A, 18B, 18C (step 216).

Therefore, from one perspective, there have been described approaches for reducing equivalent series resistance (ESR) of a power management circuit during single transmission. The power management circuit includes multiple power amplifier circuits each configured to amplify a signal for transmission. The power management circuit includes a main multi-level charge pump (MCP), a first voltage modulation circuit, a lightweight MCP, and a second voltage modulation circuit. When only one of the power amplifiers is active to amplify the signal for single transmission, the power management circuit will opportunistically couple the main MCP, the first voltage modulation circuit, the lightweight MCP, and the second voltage modulation circuit to the active power amplifier. As such, the active power amplifier will see a reduced ESR that is collectively presented by the main MCP, the first voltage modulation circuit, the lightweight MCP, and the second voltage modulation circuit, and can thus operate with improved efficiency during the single transmission.

Further examples of feature combinations taught by the present disclosure are set out in the following numbered clauses.

Clause 1. A power management circuit comprising: a plurality of power amplifier circuits each configured to amplify a signal based on one of a first modulated voltage and a second modulated voltage; a dual output voltage conversion circuit comprising: a main multi-level charge pump (MCP) configured to generate a first low-frequency voltage as a function of a battery voltage to thereby induce a first low-frequency current at a first voltage output; and a lightweight MCP configured to receive a transfer voltage higher than the battery voltage from the main MCP and generate a second low-frequency voltage as a function of the transfer voltage to thereby induce a second low-frequency current at a second voltage output; a first voltage modulation circuit configured to generate the first modulated voltage at the first voltage output based on a first modulated target voltage; a second voltage modulation circuit configured to generate the second modulated voltage at the second voltage output based on a second modulated target voltage; and a control circuit configured to: determine that only one of the plurality of power amplifier circuits is active to amplify the signal; cause the main MCP and the lightweight MCP to concurrently provide the first low-frequency current and the second low-frequency current to the determined one of the plurality of power amplifier circuits; and cause the first voltage modulation circuit and the second voltage modulation circuit to concurrently provide the first modulated voltage and the second modulated voltage to the determined one of the plurality of power amplifier circuits.

Clause 2. The power management circuit of clause 1, further comprising a switching circuit coupled between the first voltage output, the second voltage output, and the plurality of power amplifier circuits, wherein the control circuit is further configured to control the switching circuit to thereby cause the first low-frequency current, the second low-frequency current, the first modulated voltage, and the second modulated voltage to be concurrently provided to the determined one of the plurality of power amplifier circuits.

Clause 3. The power management circuit of clause 1 or 2, wherein the transfer voltage is substantially equal to twice the battery voltage.

Clause 4. The power management circuit of clause 1, 2 or 3, wherein the main MCP comprises a first buck-boost voltage converter and a second buck-boost voltage converter coupled in parallel between the battery voltage and a first low-frequency voltage output.

Clause 5. The power management circuit of clause 4, wherein each of the first buck-boost voltage converter and the second buck-boost voltage converter comprises: a respective first switch coupled between the battery voltage and a respective first middle node configured to provide the transfer voltage to the lightweight MCP; a respective pair of second switches coupled in series between the respective first middle node and the first low-frequency voltage output; a respective third switch coupled between the battery voltage and a respective second middle node; a respective fourth switch coupled between the respective second middle node and a ground; and a respective fly capacitor coupled between the respective first middle node and the respective second middle node.

Clause 6. The power management circuit of clause 5, wherein: the respective pair of second switches in the first buck-boost voltage converter are both closed when the first buck-boost voltage converter outputs the transfer voltage to the lightweight MCP via the respective first middle node; and the respective pair of second switches in the second buck-boost voltage converter are both closed when the second buck-boost voltage converter outputs the transfer voltage to the lightweight MCP via the respective first middle node.

Clause 7. The power management circuit of clause 4, wherein each of the first buck-boost voltage converter and the second buck-boost voltage converter comprises: a respective first switch coupled between the battery voltage and a respective first middle node configured to provide the transfer voltage to the lightweight MCP; a respective second switch coupled between the respective first middle node and a coupling node; a respective shared switch coupled between the coupling node and the first low-frequency voltage output; a respective third switch coupled between the battery voltage and a respective second middle node; a respective fourth switch coupled between the respective second middle node and a ground; and a respective fly capacitor coupled between the respective first middle node and the respective second middle node.

Clause 8. The power management circuit of clause 7, wherein: the respective second switch in the first buck-boost voltage converter and the shared switch are both closed when the first buck-boost voltage converter outputs the transfer voltage to the lightweight MCP via the respective first middle node; and the respective pair of second switches in the second buck-boost voltage converter and the shared switch are both closed when the second buck-boost voltage converter outputs the transfer voltage to the lightweight MCP via the respective first middle node.

Clause 9. The power management circuit of any of clauses 4 to 8, wherein the lightweight MCP comprises: a first switch coupled between the respective first middle node in the first buck-boost voltage converter and a common node; a second switch coupled between the respective first middle node in the second buck-boost voltage converter and the common node; and a third switch coupled between the common node a second low-frequency voltage output.

Clause 10. The power management circuit of clause 9, wherein: the first switch and the third switch are both opened when the transfer voltage is received via the respective first middle node in the first buck-boost voltage converter; and the second switch and the third switch are both opened when the transfer voltage is received via the respective first middle node in the second buck-boost voltage converter.

Clause 11. A wireless device comprising a power management circuit, the power management circuit comprises: a plurality of power amplifier circuits each configured to amplify a signal based on one of a first modulated voltage and a second modulated voltage; a dual output voltage conversion circuit comprising: a main multi-level charge pump (MCP) configured to generate a first low-frequency voltage as a function of a battery voltage to thereby induce a first low-frequency current at a first voltage output; and a lightweight MCP configured to receive a transfer voltage higher than the battery voltage from the main MCP and generate a second low-frequency voltage as a function of the transfer voltage to thereby induce a second low-frequency current at a second voltage output; a first voltage modulation circuit configured to generate the first modulated voltage at the first voltage output based on a first modulated target voltage; a second voltage modulation circuit configured to generate the second modulated voltage at the second voltage output based on a second modulated target voltage; and a control circuit configured to: determine that only one of the plurality of power amplifier circuits is active to amplify the signal; cause the main MCP and the lightweight MCP to concurrently provide the first low-frequency current and the second low-frequency current to the determined one of the plurality of power amplifier circuits; and cause the first voltage modulation circuit and the second voltage modulation circuit to concurrently provide the first modulated voltage and the second modulated voltage to the determined one of the plurality of power amplifier circuits.

Clause 12. The wireless device of clause 11, wherein the power management circuit further comprises a switching circuit coupled between the first voltage output, the second voltage output, and the plurality of power amplifier circuits, wherein the control circuit is further configured to control the switching circuit to thereby cause the first low-frequency current, the second low-frequency current, the first modulated voltage, and the second modulated voltage to be concurrently provided to the determined one of the plurality of power amplifier circuits.

Clause 13. The wireless device of clause 11 or 12, wherein the main MCP comprises a first buck-boost voltage converter and a second buck-boost voltage converter coupled in parallel between the battery voltage and a first low-frequency voltage output.

Clause 14. The wireless device of clause 13, wherein each of the first buck-boost voltage converter and the second buck-boost voltage converter comprises: a respective first switch coupled between the battery voltage and a respective first middle node configured to provide the transfer voltage to the lightweight MCP; a respective pair of second switches coupled in series between the respective first middle node and the first low-frequency voltage output; a respective third switch coupled between the battery voltage and a respective second middle node; a respective fourth switch coupled between the respective second middle node and a ground; and a respective fly capacitor coupled between the respective first middle node and the respective second middle node.

Clause 15. The wireless device of clause 14, wherein: the respective pair of second switches in the first buck-boost voltage converter are both closed when the first buck-boost voltage converter outputs the transfer voltage to the lightweight MCP via the respective first middle node; and the respective pair of second switches in the second buck-boost voltage converter are both closed when the second buck-boost voltage converter outputs the transfer voltage to the lightweight MCP via the respective first middle node.

Clause 16. The wireless device of clause 13, wherein each of the first buck-boost voltage converter and the second buck-boost voltage converter comprises: a respective first switch coupled between the battery voltage and a respective first middle node configured to provide the transfer voltage to the lightweight MCP; a respective second switch coupled between the respective first middle node and a coupling node; a respective shared switch coupled between the coupling node and the first low-frequency voltage output; a respective third switch coupled between the battery voltage and a respective second middle node; a respective fourth switch coupled between the respective second middle node and the ground; and a respective fly capacitor coupled between the respective first middle node and the respective second middle node.

Clause 17. The wireless device of clause 16, wherein: the respective second switch in the first buck-boost voltage converter and the shared switch are both closed when the first buck-boost voltage converter outputs the transfer voltage to the lightweight MCP via the respective first middle node; and the respective pair of second switches in the second buck-boost voltage converter and the shared switch are both closed when the second buck-boost voltage converter outputs the transfer voltage to the lightweight MCP via the respective first middle node.

Clause 18. The wireless device of any of clauses 13 to 17, wherein the lightweight MCP comprises: a first switch coupled between the respective first middle node in the first buck-boost voltage converter and a common node; a second switch coupled between the respective first middle node in the second buck-boost voltage converter and the common node; and a third switch coupled between the common node and a second low-frequency voltage output.

Clause 19. The wireless device of clause 18, wherein: the first switch and the third switch are both opened when the transfer voltage is received via the respective first middle node in the first buck-boost voltage converter; and the second switch and the third switch are both opened when the transfer voltage is received via the respective first middle node in the second buck-boost voltage converter.

Clause 20. A method for reducing equivalent series resistance (ESR) of a power management circuit during single transmission comprising: amplifying a signal based on one of a first modulated voltage and a second modulated voltage; generating a first low-frequency voltage as a function of a battery voltage to thereby induce a first low-frequency current at a first voltage output; receiving a transfer voltage higher than the battery voltage and generating a second low-frequency voltage as a function of the transfer voltage to thereby induce a second low-frequency current at a second voltage output; generating the first modulated voltage at the first voltage output based on a first modulated target voltage; generating the second modulated voltage at the second voltage output based on a second modulated target voltage; determining that only one of a plurality of power amplifier circuits is active to amplify the signal; concurrently providing the first low-frequency current and the second low-frequency current to the determined one of the plurality of power amplifier circuits; and concurrently providing the first modulated voltage and the second modulated voltage to the determined one of the plurality of power amplifier circuits.

Those skilled in the art will recognize improvements and modifications to the illustrative embodiments of the present disclosure. All such improvements and modifications are considered within the scope of the concepts disclosed herein and the claims that follow.

## Claims

1. A power management circuit comprising:
a plurality of power amplifier circuits each configured to amplify a signal based on one of a first modulated voltage and a second modulated voltage;
a dual output voltage conversion circuit comprising:
a main multi-level charge pump (MCP) configured to generate a first low-frequency voltage as a function of a battery voltage to thereby induce a first low-frequency current at a first voltage output; and
a lightweight MCP configured to receive a transfer voltage higher than the battery voltage from the main MCP and generate a second low-frequency voltage as a function of the transfer voltage to thereby induce a second low-frequency current at a second voltage output;
a first voltage modulation circuit configured to generate the first modulated voltage at the first voltage output based on a first modulated target voltage;
a second voltage modulation circuit configured to generate the second modulated voltage at the second voltage output based on a second modulated target voltage; and
a control circuit configured to:
determine that only one of the plurality of power amplifier circuits is active to amplify the signal;
cause the main MCP and the lightweight MCP to concurrently provide the first low-frequency current and the second low-frequency current to the determined one of the plurality of power amplifier circuits; and
cause the first voltage modulation circuit and the second voltage modulation circuit to concurrently provide the first modulated voltage and the second modulated voltage to the determined one of the plurality of power amplifier circuits.

2. The power management circuit of claim 1, further comprising a switching circuit coupled between the first voltage output, the second voltage output, and the plurality of power amplifier circuits, wherein the control circuit is further configured to control the switching circuit to thereby cause the first low-frequency current, the second low-frequency current, the first modulated voltage, and the second modulated voltage to be concurrently provided to the determined one of the plurality of power amplifier circuits.

3. The power management circuit of claim 1 or 2, wherein the transfer voltage is substantially equal to twice the battery voltage.

4. The power management circuit of claim 1, 2 or 3, wherein the main MCP comprises a first buck-boost voltage converter and a second buck-boost voltage converter coupled in parallel between the battery voltage and a first low-frequency voltage output.

5. The power management circuit of claim 4, wherein each of the first buck-boost voltage converter and the second buck-boost voltage converter comprises:
a respective first switch coupled between the battery voltage and a respective first middle node configured to provide the transfer voltage to the lightweight MCP;
a respective pair of second switches coupled in series between the respective first middle node and the first low-frequency voltage output;
a respective third switch coupled between the battery voltage and a respective second middle node;
a respective fourth switch coupled between the respective second middle node and a ground; and
a respective fly capacitor coupled between the respective first middle node and the respective second middle node.

6. The power management circuit of claim 5, wherein:
the respective pair of second switches in the first buck-boost voltage converter are both closed when the first buck-boost voltage converter outputs the transfer voltage to the lightweight MCP via the respective first middle node; and
the respective pair of second switches in the second buck-boost voltage converter are both closed when the second buck-boost voltage converter outputs the transfer voltage to the lightweight MCP via the respective first middle node.

7. The power management circuit of claim 4, wherein each of the first buck-boost voltage converter and the second buck-boost voltage converter comprises:
a respective first switch coupled between the battery voltage and a respective first middle node configured to provide the transfer voltage to the lightweight MCP;
a respective second switch coupled between the respective first middle node and a coupling node;
a respective shared switch coupled between the coupling node and the first low-frequency voltage output;
a respective third switch coupled between the battery voltage and a respective second middle node;
a respective fourth switch coupled between the respective second middle node and a ground; and
a respective fly capacitor coupled between the respective first middle node and the respective second middle node.

8. The power management circuit of claim 7, wherein:
the respective second switch in the first buck-boost voltage converter and the shared switch are both closed when the first buck-boost voltage converter outputs the transfer voltage to the lightweight MCP via the respective first middle node; and
the respective pair of second switches in the second buck-boost voltage converter and the shared switch are both closed when the second buck-boost voltage converter outputs the transfer voltage to the lightweight MCP via the respective first middle node.

9. The power management circuit of any of claims 4 to 8, wherein the lightweight MCP comprises:
a first switch coupled between the respective first middle node in the first buck-boost voltage converter and a common node;
a second switch coupled between the respective first middle node in the second buck-boost voltage converter and the common node; and
a third switch coupled between the common node a second low-frequency voltage output.

10. The power management circuit of claim 9, wherein:
the first switch and the third switch are both opened when the transfer voltage is received via the respective first middle node in the first buck-boost voltage converter; and
the second switch and the third switch are both opened when the transfer voltage is received via the respective first middle node in the second buck-boost voltage converter.

11. A wireless device comprising the power management circuit of any preceding claim.

12. A method for reducing equivalent series resistance (ESR) of a power management circuit during single transmission comprising:
amplifying a signal based on one of a first modulated voltage and a second modulated voltage;
generating a first low-frequency voltage as a function of a battery voltage to thereby induce a first low-frequency current at a first voltage output;
receiving a transfer voltage higher than the battery voltage and generating a second low-frequency voltage as a function of the transfer voltage to thereby induce a second low-frequency current at a second voltage output;
generating the first modulated voltage at the first voltage output based on a first modulated target voltage;
generating the second modulated voltage at the second voltage output based on a second modulated target voltage;
determining that only one of a plurality of power amplifier circuits is active to amplify the signal;
concurrently providing the first low-frequency current and the second low-frequency current to the determined one of the plurality of power amplifier circuits; and
concurrently providing the first modulated voltage and the second modulated
voltage to the determined one of the plurality of power amplifier circuits.

13. The method of claim 12, further comprising steps corresponding to utilizing the functionality provided by any of claims 2 to 10.
